# EUROPEAN PATENT APPLICATION

(11) **EP 3 678 458 A1**
(43) Date of publication of application: **08.07.2020**
(21) Application number: 18851668.6
(22) Date of filing: 30.08.2018
(51) Int. Cl.: H05K 1/02

(54) **TRANSMISSION APPARATUS FOR TERMINAL DEVICE WIFI CIRCUIT, AND PREPARATION METHOD THEREFOR**

(30) Priority: 30.08.2017 CN 201710765189
(71) Applicant: ZTE Corporation, Shenzhen, Guangdong 518057 (CN)
(72) Inventor: WANG, Hao, Shenzhen Guangdong 518057 (CN)
(74) Representative: Hervouet-Malbec, Sylvie
(86) International application number: PCT/CN2018/103241
(87) International publication number: WO 2019/042352

(57) **Abstract**

Provided is a transmission apparatus for a WiFi circuit of a terminal device including a printed circuit board, a WiFi chip and an antenna, and the transmission apparatus includes: a transmission element embedded onto the printed circuit board and forming a closed path; a first transition element connected between the transmission element and the WiFi chip so that the transmission element and the WiFi chip have impedance continuity; and a second transition element connected between the transmission element and the antenna so that the transmission element and the antenna have impedance continuity, wherein the transmission element is provided with two rows of metal via holes cut through in a thickness direction of the transmission element so that a channel for transmission of millimeter wave signal is formed between the two rows of metal via holes. In addition, the disclosure also provides a preparing method of the transmission apparatus.

## Description

### TECHNICAL FIELD

The present disclosure relates to, but is not limited to, the field of mobile communication technologies.

### BACKGROUND

With the development of science and technology, people have higher and higher requirements on data transmission rate. To meet high-rate demands of the market, the Wireless Fidelity (WiFi) alliance has released a new standard, i.e., 802.llad. This standard adopts a 60 GHz millimeter wave frequency band to satisfy the high-rate demands, but this frequency band is weak in penetration. Therefore, it is necessary to design a circuit that involves the minimum signal loss during signal transmission.

Generally, a transmission circuit in a terminal device is implemented in two ways: in a form of a coaxial line and in a form of a microstrip line. The coaxial line has advantages of good shielding property, low loss and the like, but in the millimeter wave frequency band, a very high processing precision of the coaxial line is required because of a short wavelength, which will undoubtedly increase the cost. The microstrip line has advantages of small size, easy processibility and the like, but an open circuit structure thereof greatly increases radiation loss of signals in the millimeter wave frequency band, thereby causing certain influence on the circuit performance. Since the 802.11ad standard is not yet commercialized in a large scale, a problem about how a terminal device implements a transmission circuit of the millimeter wave frequency band remains to be solved.

### SUMMARY

According to an aspect of the present disclosure, there is provided a transmission apparatus for a WiFi circuit of a terminal device, the WiFi circuit of the terminal device includes a printed circuit board, a WiFi chip and an antenna, and the transmission apparatus includes: a transmission element embedded onto the printed circuit board and forming a closed path; a first transition element connected between the transmission element and the WiFi chip so that the transmission element and the WiFi chip have impedance continuity; and a second transition element connected between the transmission element and the antenna so that the transmission element and the antenna have impedance continuity, wherein the transmission element is provided with two rows of metal via holes cut through in a thickness direction of the transmission element so that a channel for transmission of millimeter wave signal is formed between the two rows of metal via holes.

According to another aspect of the present disclosure, there is further provided a preparing method of a transmission apparatus for a WiFi circuit of a terminal device, the WiFi circuit of the terminal device includes a printed circuit board, a WiFi chip and an antenna, and the method includes: embedding a transmission element that forms a closed path on the printed circuit board; connecting the transmission element with the WiFi chip through a first transition element; and connecting the transmission element with the antenna through a second transition element, wherein the transmission element is provided with two rows of metal via holes cut through in a thickness direction of the transmission element so that a channel for transmission of millimeter wave signal is formed between the two rows of metal via holes.

### BRIEF DESCRIPTION OF THE DRAWINGS

Accompanying drawings are provided for further understanding of the embodiments of the disclosure and constitute a part of the specification. Hereinafter, these drawings are intended to explain the disclosure together with the following embodiments, but should not be considered as a limitation to the disclosure. In the drawings:
FIG. 1 is a schematic diagram of a transmission apparatus according to an embodiment of the present disclosure;
FIG. 2 is a perspective view of a transmission element in a transmission apparatus according to an embodiment of the present disclosure;
FIG. 3 is a front view of a transmission element in a transmission apparatus according to an embodiment of the disclosure;
FIG. 4 is a side view of a transmission element in a transmission apparatus according to an embodiment of the present disclosure;
FIG. 5 is a structural dimension diagram of a transmission element in a transmission apparatus according to an embodiment of the disclosure;
FIG. 6 is a schematic diagram of a transmission path for the transmission element in the transmission apparatus shown in FIG 2 according to an embodiment of the disclosure;
FIG. 7 is a front view of the transmission element shown in FIG. 6; and
FIG. 8 is a schematic diagram of a system including a transmission apparatus according to an embodiment of the present disclosure;
FIG. 9 is a schematic diagram of a WiFi circuit in a form of a microstrip on a printed circuit board in a comparative example; and
FIG. 10 is a graph comparing signal loss in WiFi frequency bands for an embodiment of the disclosure and a comparative example.

### DETAILED DESCRIPTION

Hereinafter, preferred embodiments of the present disclosure will be described with respect to the accompanying drawings. It will be appreciated that the preferred embodiments as set forth herein are merely for the purpose of illustration and explanation of the disclosure and should not be constructed as a limitation thereof.

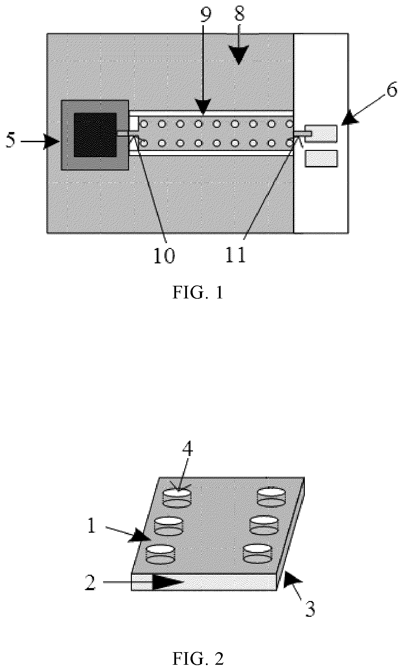

FIG. 1 is a schematic diagram of a transmission apparatus according to an embodiment of the present disclosure.

As shown in FIG. 1, a transmission apparatus according to an embodiment of the present disclosure may be used for a WiFi circuit of a terminal device. The WiFi circuit of the terminal device may include a printed circuit board 8, a WiFi chip 5 and an antenna 6, and the transmission apparatus may be located between the antenna 6 and the WiFi chip 5. As shown in FIG. 1, the transmission apparatus according to the embodiment of the present disclosure may include: a transmission element 9 embedded onto the printed circuit board 8 of the terminal device and forming a closed path; a first transition element 10 connected between the transmission element 9 and the WiFi chip 5 so that the transmission element 9 and the WiFi chip 5 have impedance continuity; and a second transition element 11 connected between the transmission element 9 and the antenna 6 so that the transmission element 9 and the antenna 6 have impedance continuity. The transmission element 9 is provided with two rows of metal via holes 4 cut through a thickness direction of the transmission element 9 so that a channel for transmission of millimeter wave signal is formed between the two rows of metal via holes 4.

When the terminal device works in a millimeter wave frequency band under an 802.11ad standard, a distribution effect is obvious for centralized devices due to the short wavelength at the frequency band. Thus, there is a great signal loss during transmission, reducing performance of the system. For an application scenario where a terminal device transmits millimeter wave signal, the present disclosure proposes, with controlled cost, a transmission apparatus that transmits millimeter wave signal to an antenna, and then transmits a signal received by the antenna to a high frequency device for analyzing and processing so that the loss is minimized during the signal transmission process, and the system remains in good performance. With the application of the 802.11ad standard in Virtual Reality (VR) helmets and Internet of Things equipment, the transmission apparatus according to the present disclosure has a good application prospect.

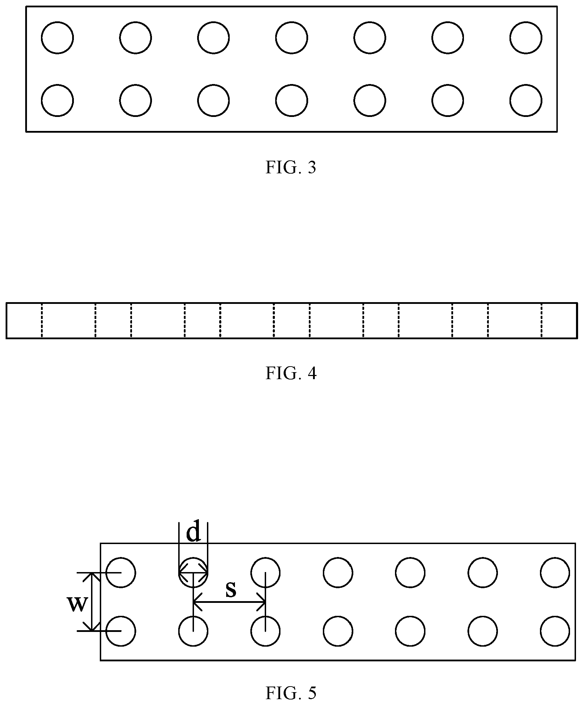

As shown in FIG. 1, the transmission apparatus according to the embodiment of the present disclosure includes a transmission element 9 forming a closed path. FIGs. 2 to 4 show the structure of the transmission element 9. FIG. 2 is a perspective view of the transmission element 9 in a transmission apparatus according to an embodiment of the present disclosure, FIG. 3 is a front view of the transmission element 9 in a transmission apparatus according to an embodiment of the disclosure, and FIG. 4 is a side view of the transmission element 9 in an transmission apparatus according to an embodiment of the present disclosure.

Referring to FIGs. 2 to 4, the transmission element 9 of the transmission apparatus according to the embodiment of the present disclosure has a cuboid shape, and may include: a dielectric layer 2; an upper metal layer 1 arranged on an upper surface of the dielectric layer 2; and a lower metal layer 3 arranged on a lower surface of the dielectric layer 2. The metal via holes 4 penetrate through the upper metal layer 1, the dielectric layer 2 and the lower metal layer 3 from top to bottom in sequence. The metal via holes 4 are arranged in two parallel rows, and upper and lower ends of each metal via hole 4 are respectively conducted with the upper metal layer 1 and the lower metal layer 3.

The upper metal layer 1, the lower metal layer 3 and the metal via holes 4 may be formed by electroplating or other prior art methods using copper, gold and the like. Each of the metal via holes 4 may have a round or square shape, or may have other symmetrical shapes, and the two rows of the metal via holes 4 are uniformly distributed. According to an embodiment of the present disclosure, round or square metal via holes 4 may be used.

FIG. 5 is a structural dimension diagram of a transmission element in a transmission apparatus according to an embodiment of the disclosure.

Referring to FIG. 5, a spacing W between the two rows of metal via holes, a spacing S between adjacent metal via holes in each row of metal via holes, and a diameter or side length d of each of the metal via holes may be determined according to a wavelength λ of the transmitted millimeter wave. The spacing W satisfies: 1λ≤W≤2λ, the spacing S satisfies: S≤ 0.4λ, and the diameter (or side length) d satisfies: d≤0.2λ.

Since the 802.11ad standard specifies a 60 GHz millimeter wave frequency band (57 GHz to 66 GHz) as the transmission frequency band, a size of the transmission element may be determined according to the wavelength of the transmission frequency band. As shown in FIG. 5 (the metal via holes are illustrated to be round), W is 2.94±0.02 mm, S is 0.7±0.02 mm, and the diameter d is 0.4±0.02 mm (d is a side length when the metal via holes are square).

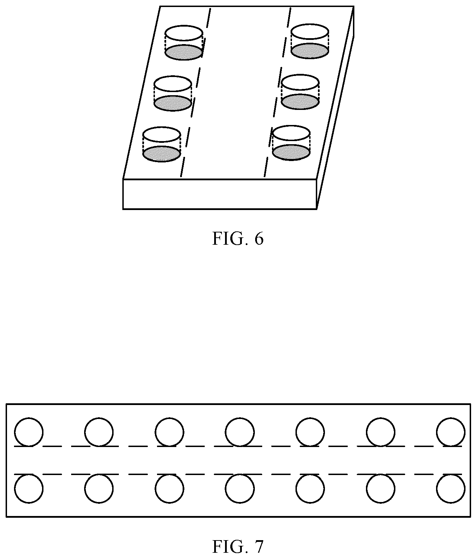

The transmission element in the transmission apparatus according to the embodiment of the present disclosure has low loss and large capacity, and is not easy to generate problems such as electromagnetic interference (EMI). FIGs. 6 and 7 show schematic diagrams of a transmission path of the transmission element. FIG. 6 is a schematic diagram of a transmission path for the transmission element in the transmission apparatus shown in FIG. 2 according to an embodiment of the disclosure, and FIG. 7 is a front view of the transmission element shown in FIG. 6.

As shown in FIGs. 6 and 7, since the sizes of the diameter d and the spacing S of the via holes in the transmission element are much smaller than the wavelength of the millimeter wave in the 60 GHz frequency band, thus a periphery of the whole transmission element is equivalent to a closed metal layer, and signal transmission happens only in a channel part between the two dotted lines shown in FIGs. 6 and 7. This kind of closed path hardly enables signal radiation outside of the transmission element, and is thus not easily to interfere or be interfered by the outside, thereby reducing the signal loss and improving the signal transmission quality.

The transmission apparatus according to the embodiment of the present disclosure further includes a first transition element 10 connected between the transmission element 9 and the WiFi chip 5, and a second transition element 11 connected between the transmission element 9 and the antenna 6. The first transition element 10 and the second transition element 11 may be microstrip lines respectively connected to two ends of the transmission element 9. The first transition element 10 has an end connected to the WiFi chip 5 having a size adapted to a size of a signal transceiver pin of the WiFi chip 5, and the second transition element 11 has a shape and a size that may be determined according to impedance of the antenna 6.

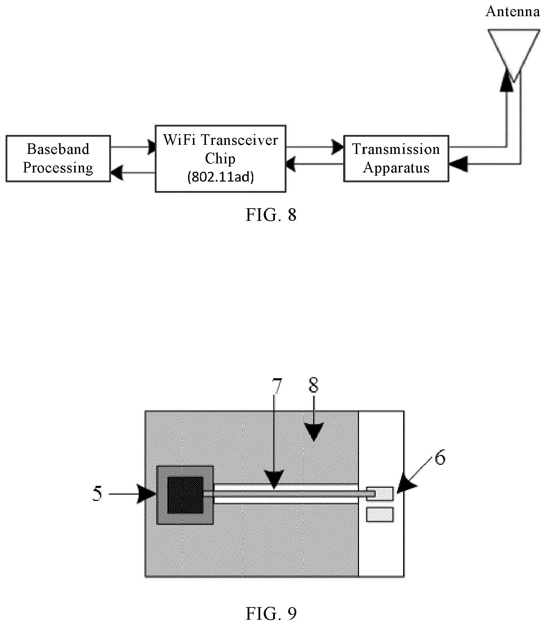

FIG. 8 is a schematic diagram of a system including a transmission apparatus according to an embodiment of the present disclosure.

Referring to FIGs. 8 and 1, the transmission apparatus according to the embodiment of the present disclosure, located between an antenna (the antenna 6 shown in FIG. 1) and a WiFi transceiver chip (the WiFi chip 5 shown in FIG. 1), may transmit millimeter wave signal to the antenna, and then transmit the signal received by the antenna to a high frequency device (for example, the WiFi chip 5) for analyzing and processing, which signal is then transmitted to a baseband by the WiFi chip 5 for processing. The microstrip lines are provided between the transmission element 9 and the WiFi chip 5 because the signal transceiver pin of the WiFi chip 5 has a smaller size than the transmission element 9, and if the pin is directly connected to the transmission element 9, discontinuity of impedance will occur. The pin is led out by a small section of microstrip line and then connected with the transmission element 9. A transition of the signal occurs between the transmission element 9 and the WiFi chip 5 so that the transmission element 9 and the WiFi chip 5 have matched impedance and signal reflection is reduced. Similarly, a microstrip line provided between the transmission element 9 and the antenna 6 makes the antenna 6 and the transmission element 9 have signal impedance continuity.

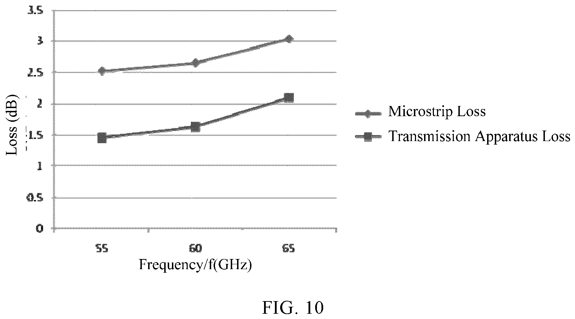

FIG. 9 is a schematic diagram of a WiFi circuit in a form of a microstrip on a printed circuit board in a comparative example, and FIG. 10 is a graph comparing signal loss in WiFi frequency bands for an embodiment of the disclosure and a comparative example.

As shown in FIG. 9, a WiFi circuit 7 in a form of a microstrip is formed on the printed circuit board 8. The transmission apparatus according to the embodiment of the present disclosure uses a same material as the microstrip line structure, and the signal loss of the two structures in the frequency band under the 802.11ad standard are compared with a same length, as shown in FIG 10. As can be seen from the figure, the transmission apparatus according to the embodiment of the present disclosure has an improvement of more than 1dB in signal loss compared with the microstrip line structure.

According to an embodiment of the present disclosure, there is further provided a preparing method of the transmission apparatus as described above, including: embedding a transmission element 9 that forms a closed path on a printed circuit board 8 in a WiFi circuit of a terminal device; connecting the transmission element 9 with the WiFi chip 5 through a first transition element 10; and connecting the transmission element 9 with the antenna 6 through a second transition element 11, wherein the transmission element 9 is provided with two rows of metal via holes 4 cut through in a thickness direction of the transmission element 9 so that a channel for transmission of millimeter wave signal is formed between the two rows of metal via holes 4.

The transmission element 9 may include an upper metal layer 1, a dielectric layer 2, and a lower metal layer 3. During preparation of the transmission element 9, two rows of parallel holes may be provided in the dielectric layer 2, and then the upper metal layer 1, the lower metal layer 3, and the metal via holes 4 in conduction with the upper metal layer 1 and the lower metal layer 3 are respectively formed on the upper surface, the lower surface, and the holes of the dielectric layer 2 by electroplating metals such as copper, gold, and the like.

A spacing W between the two rows of metal via holes 4, a spacing S between adjacent metal via holes 4 in each row of metal via holes 4, and a diameter or side length d of each of the metal via holes 4 may be determined according to a wavelength λ of the transmitted millimeter waves.

The transmission apparatus for the WiFi circuit of the terminal device has the following advantages.
1. The radiation loss is low, and the design of a millimeter wave circuit can be realized on a printed circuit board material and combined with a microstrip circuit so that the effective transmission of millimeter wave signal is ensured on a premise of reducing the requirement on processing precision.
2. The millimeter wave signal can be transmitted to the antenna, and the signal received by the antenna is transmitted to a high frequency device for analyzing and processing so that low loss is achieved during the signal transmission process, and the system remains in good performance while the cost is under control.
3. By combining the transmission element with the transition elements, the impedance continuity as well as low signal loss and large capacity are achieved, which is not easy to interfere or be interfered by the outside, thereby improving the signal transmission quality.

The foregoing is implementations of the present disclosure, and it should be noted that modifications and refinements may be made by those skilled in the art without departing from the principles of the disclosure and these modifications and changes should be considered as within the scope of the disclosure.

## Claims

1. A transmission apparatus for a Wireless Fidelity (WiFi) circuit of a terminal device, the WiFi circuit of the terminal device comprising a printed circuit board, a WiFi chip and an antenna, and the transmission apparatus comprising: a transmission element, a first transition element, and a second transition element, wherein
the transmission element is embedded on the printed circuit board and forms a closed path,
the first transition element is connected between the transmission element and the WiFi chip so that the transmission element and the WiFi chip have impedance continuity, and
the second transition element is connected between the transmission element and the antenna so that the transmission element and the antenna have impedance continuity,
wherein the transmission element is provided with two rows of metal via holes cut through in a thickness direction of the transmission element so that a channel for transmission of millimeter wave signal is formed between the two rows of metal via holes.

2. The transmission apparatus according to claim 1, wherein the transmission element comprises:
a dielectric layer;
an upper metal layer arranged on an upper surface of the dielectric layer; and
a lower metal layer arranged on a lower surface of the dielectric layer,
wherein the metal via holes penetrate through the upper metal layer, the dielectric layer and the lower metal layer from top to bottom in sequence.

3. The transmission apparatus according to claim 1, wherein the first transition element and the second transition element are microstrip lines respectively connected to two ends of the transmission element.

4. The transmission apparatus according to claim 3, wherein the first transition element has an end connected to the WiFi chip having a size adapted to a size of a signal transceiver pin of the WiFi chip.

5. The transmission apparatus according to claim 3, wherein the second transition element has a shape and a size determined according to impedance of the antenna.

6. The transmission apparatus according to any one of claims 1 to 3, wherein a spacing W between the two rows of metal via holes satisfies: 1λ≤W≤2λ,
where λ is a wavelength of the millimeter wave.

7. The transmission apparatus according to claim 6, wherein a spacing S between adjacent metal via holes in each row of metal via holes satisfies: S≤ 0.4λ.

8. The transmission apparatus according to claim 7, wherein a diameter or side length d of each of the metal via holes satisfies: d≤0.2λ.

9. The transmission apparatus according to claim 1, wherein the WiFi chip satisfies an 802.11ad standard, and the millimeter wave has a millimeter wave frequency band under the 802.11ad standard.

10. A preparing method of a transmission apparatus for a Wireless Fidelity (WiFi) circuit of a terminal device, the WiFi circuit of the terminal device comprising a printed circuit board, a WiFi chip and an antenna, and the method comprising:
embedding a transmission element that forms a closed path on the printed circuit board;
connecting the transmission element with the WiFi chip through a first transition element; and
connecting the transmission element with the antenna through a second transition element,
wherein the transmission element is provided with two rows of metal via holes cut through in a thickness direction of the transmission element so that a channel for transmission of millimeter wave signal is formed between the two rows of metal via holes.

11. The preparing method according to claim 10, wherein a spacing W between the two rows of metal via holes satisfies: 1λ≤W≤2λ,
a spacing S between adjacent metal via holes in each row of metal via holes satisfies: S≤0.4λ, and
a diameter or side length d of each of the metal via holes satisfies: d≤0.2λ,
where λ is a wavelength of the millimeter wave.

12. The preparing method according to claim 10, wherein the WiFi chip satisfies an 802.11ad standard, and the millimeter wave has a millimeter wave frequency band under the 802.11ad standard.
